# FASCICULE DE BREVET EUROPEEN

(11) **EP 0 718 067 B1**
(45) Date de publication et mention de la délivrance du brevet: **01.09.1999**
(21) Numéro de dépôt: 95402849.4
(22) Date de dépôt: 18.12.1995
(51) Int. Cl.: B23K 1/008, H01L 21/00

(54) **Four à hybridation pour l'interconnexion de composants par un matériau fusible**
Hybridisierungsofen für die Verbindung von Bauelementen mittels eines schmelzbares Materials
Hybridization oven for interconnection of components using a fusible material

(30) Priorité: 20.12.1994 FR 9415312
(43) Date de publication de la demande: 26.06.1996
(73) Titulaire: COMMISSARIAT A L'ENERGIE ATOMIQUE, 75015 Paris Cédex 15 (FR)
(72) Inventeur: Caillat, Patrice, F-38130 Echirolles (FR); Parat, Guy, F-38130 Echirolles (FR)
(74) Mandataire: Dubois-Chabert, Guy

(56) Documents cités:
- EP-A- 0 180 010
- EP-A- 0 374 475
- FR-A- 2 318 702
- US-A- 5 341 980

## Description

### Domaine technique

La présente invention concerne un four à hybridation pour l'interconnexion de composants par un matériau fusible. L'interconnexion par matériau fusible désignée encore par "flip-chip" permet de connecter électriquement et/ou mécaniquement entre eux des composants. Elle permet, par exemple, de reporter sur un substrat d'interconnexion une ou plusieurs puces électroniques. L'invention s'applique dans tous les domaines où, en raison du nombre grandissant d'entrées et de sorties, l'interconnexion par matériau fusible se supplante aux techniques connues de liaison par fil ou "wire-bounding" ou de montage sur bande dite T.A.B. (Tape Automatic Bounding).

L'invention s'applique également à la réalisation de modules multipuces pour lesquelles la solution du "flip-chip" est retenue en raison d'impératifs liés à la surface utile de silicium par exemple et à la vitesse de signal dans les interconnexions.

L'invention s'applique enfin à la fabrication de composants destinés aux équipements à grande diffusion dans lesquels les impératifs de coût sont draconiens et où on note, de ce fait, l'émergence de besoins d'interconnexions par "flip-chip" sur des supports autres que le silicium, c'est-à-dire, par exemple, l'alumine ou même de simples circuits imprimés ("chip on board").

### Etat de la technique antérieure

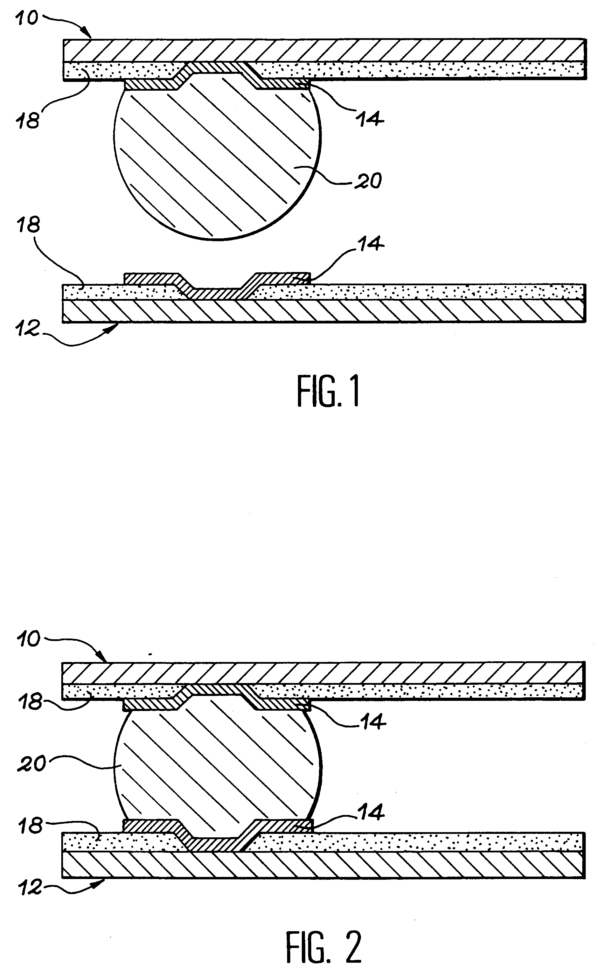

Les figures 1 et 2, annexées permettent de résumer le procédé connu de report par "flip chip".

Deux composants 10, 12, tels que par exemple une puce 10 et un substrat d'interconnexion 12 sont disposés face à face. Chaque composant comporte un plot d'accrochage 14 en un matériau mouillable par le matériau fusible d'interconnexion et entouré par une couche 18 de matériau isolant non mouillable. Le plot d'accrochage 14 comporte en général une ou plusieurs couches conductrices et correspond par exemple à une entrée ou une sortie du composant. Une bille de matériau fusible 20, par exemple en SnPb (60-40) est formée sur le plot d'accrochage de l'un des composants, en l'occurrence, le plot 14 du composant 10.

L'ensemble est alors porté à une température T supérieure ou égale à la température de fusion du matériau de la bille 20. La bille 20, mise en contact avec le plot d'accrochage du composant 12 permet, comme le montre la figure 2, de relier les plots d'accrochage en réalisant une sorte de brasage. La température est ensuite ramenée à la température ambiante à laquelle le matériau de la bille 20 est solidifié.

Un des problèmes majeurs qui se pose dans l'opération de report décrite ci-dessus est posé par la désoxydation du matériau fusible, utilisé pour l'interconnexion. Ainsi, avant le report dépose-t-on généralement un flux tel qu'un fluide désoxydant à base de résine sur les billes de matériau ou sur les plots de contact à braser. Ce flux, en désoxydant la bille pendant le chauffage à la température T, permet une soudure correcte.

Cependant, le procédé nécessite dans ce cas une opération supplémentaire de nettoyage des résidus après le brasage. De plus, dans certaines applications, le fait de déposer en phase liquide un composé (flux) sur une puce finie peut être générateur de problèmes de corrosion et de fiabilité des composants dans le temps.

Ainsi essaye-t-on d'envisager des solutions pour une soudure sans flux lors des opérations d'interconnexion.

Une première solution connue consiste à effectuer un bombardement ionique des billes suivi d'un chauffage sous vide des composants à braser. Ce procédé est cependant très complexe et est incompatible avec les exigences d'une production en série.

Une seconde solution consiste à chauffer les composants sous atmosphère réductrice. Lors de l'hybridation, les composants et le matériau fusible sont alors soumis à une atmosphère par exemple d'hydrogène ou de vapeurs d'acide acétique. Pour avoir une efficacité réelle, l'hydrogène utilisé doit être pur, ce qui pose des problèmes de coût et de sécurité liés à l'utilisation de ce type de gaz qui rendent cette solution également incompatible avec les applications envisagées.

Une troisième solution connue, permettant de travailler avec des gaz faiblement chargés en hydrogène, consiste à combiner l'utilisation du gaz réducteur avec un catalyseur déposé sur les parties à braser. Ce catalyseur est choisi généralement dans les métaux du groupe VIIIB de la classification périodique des éléments du tableau Mendeleïev.

Les propriétés de dissociation des molécules d'hydrogène en ions hydrogène de ces métaux, tels que le platine ou le palladium, sont mis à profit en vue de la réduction des oxydes et en particulier des oxydes d'étain-plomb (SnPb). Une autre propriété, notamment du palladium, qui est mise à profit, est celle de permettre aux températures de brasage, c'est-à-dire de l'ordre de 250°C, une migration des ions hydrogène H+ vers l'oxyde formé notamment sur le matériau fusible à travers la couche de palladium. Ainsi, le matériau fusible et/ou le plot d'accrochage récepteur de la bille sont recouverts d'une couche par exemple de palladium. Le fait d'interposer une couche de palladium entre les deux parties à braser permet de créer des ions hydrogène H+ là où ils sont utiles, ce qui est particulièrement intéressant dans les fours a hybridation à passage. Pour d'autres détails de cette technique, on peut se reporter utilement au document US-A-5 048 744.

Cette solution, bien que séduisante, nécessite toutefois un traitement préalable des billes de matériau fusible et/ou de plots avec du palladium. De plus, lors de l'hybridation, on crée alors une brasure ternaire en raison du palladium dont l'effet sur la ductilité des billes peut être gênant.

Le document EP-A-0 180 010 décrit un four à circulation dans lequel on coiffe les composants à traiter d'une cage grillagée, recouverte d'un catalyseur tel que le platine. Ce document contient par ailleurs les caractéristiques du préambule de la revendication 1.

La présente invention a pour objet un four à hybridation qui permette un brasage sans flux et qui ne présente pas les inconvénients ou limitations évoqués ci-dessus.

Un autre objet de l'invention est un four à hybridation de structure simple et qui soit adapté aux exigences d'une production en série et qui permette d'excellents rendements d'hybridation.

### Exposé de l'invention

Pour atteindre ces objectifs, l'invention concerne plus précisément un four à hybridation pour l'interconnexion de composants par un matériau fusible selon la revendication 1.

Il s'avère qu'avec un four conforme à l'invention, qui allie d'une part l'utilisation d'une surface préférentiellement importante de catalyseur et d'autre part un volume intérieur préférentiellement ajusté par rapport aux composants à hybrider, la couche de palladium ou de platine permet de concentrer des ions hydrogène H+ obtenus à partir du mélange initial de gaz réducteur dans une zone très proche des parties à braser et ainsi obtenir un excellent rendement de brasage sans avoir recours à un dépôt directement sur les billes et/ou les plots.

On peut noter que le catalyseur permet de réaliser une réaction de surface de désoxydation de la soudure. Son rôle essentiel n'est pas de transformer l'oxygène mais de réduire les oxydes présents sur la soudure.

Selon un aspect de l'invention, les moyens pour faire circuler un flux de gaz peuvent comporter une buse d'introduction de gaz et un échappement, la buse et l'échappement présentant respectivement un débit d'entrée et un débit de sortie de gaz choisis pour créer un flux laminaire de gaz.

Ces précautions supplémentaires permettent d'éviter tout écoulement turbulent du gaz dans l'enceinte au niveau des composants à hybrider. De même, le débit du gaz réducteur peut être avantageusement choisi pour obtenir une accélération conséquente du gaz à la sortie de l'enceinte et ainsi éviter toute rétrodiffusion d'oxygène vers la zone de traitement.

Pour réduire encore les risques de turbulences, il est possible d'équiper la buse d'un diffuseur.

De plus, le débit d'entrée et le débit de sortie peuvent de préférence être choisis pour que l'enceinte contienne moins de 50 ppm d'oxygène.

Selon un autre aspect de l'invention, les moyens de chauffage du four peuvent comporter une sole chauffante présentant une bonne capacité de montée en température, ceci permettant d'éviter au maximum toute réoxydation du matériau fusible.

Selon une réalisation particulière de l'invention, la buse d'introduction de gaz réducteur présente des parois supérieure et latérale et est disposée au-dessus de la sole chauffante pour former avec la sole, l'enceinte du four à hybridation. Un échappement de gaz réducteur peut être prévu en disposant une ou plusieurs cales entre la paroi latérale de la buse et la sole chauffante afin d'y ménager un espacement.

La minimisation du volume libre autour des composants à hybrider et la limitation de la rétrodiffusion d'oxygène, obtenue notamment en ajustant l'espacement entre la sole et les parois de la buse, permet de minimiser le taux d'oxygène présent dans le four.

### Brève description des figures

D'autres caractéristiques et avantages de la présente invention ressortiront mieux de la description qui va suivre, donnée à titre purement illustratif et nullement limitatif, en référence aux dessins annexés sur lesquels :
- les figures 1 et 2, déjà décrites, sont des coupes schématiques de deux composants à hybrider et illustrent un procédé d'hybridation par matériau fusible dit "flip-chip",
- la figure 3 est une coupe schématique d'un four à hybridation conforme à l'invention,
- la figure 4 est une coupe IV-IV schématique du four de la figure 3.

### Description détaillée d'un mode de mise en oeuvre de l'invention

Le four représenté à la figure 1 comporte une buse d'introduction du gaz réducteur qui porte la référence générale 100.

La buse 100 de forme circulaire comporte une paroi supérieure 102 et une paroi latérale 104. La buse 100 est disposée au-dessus d'une sole chauffante 108 avec laquelle elle forme l'enceinte qui présente un espace intérieur 106 pour recevoir des composants à hybrider 120.

La buse 100 comporte en outre une plaque 110 percée de trous et qui forme un diffuseur. Cette plaque 110 étant disposée entre une arrivée de gaz 112 de la buse et les composants dans l'espace intérieur 106.

Conformément à l'invention, la surface intérieure des parois de l'enceinte est, au moins en partie recouverte de préférence avec une couche de matériau comportant un élément choisi dans le groupe VIIIB. Cette couche est par exemple en palladium. Cette couche référencée 114 tapisse dans le cas du présent exemple la face intérieure 103 de la paroi 104 de la buse, la face 111 de la plaque 110 en regard des composants et la surface 116 de la sole 108, à l'intérieur du four.

De préférence, le volume de l'espace intérieur du four est réduit au maximum et est adapté à une famille de composants de même encombrement, ce qui permet de rapprocher au plus près les parois recouvertes de palladium des parties à braser.

La sole chauffante 108 présente de préférence une bonne capacité de montée en température, par exemple, supérieure ou égale à 3°C/s pour arriver à la température de fusion du matériau fusible. La sole peut être par exemple une sole du type à infrarouge capable d'une montée en température typiquement de 200°C/minute.

Selon une réalisation particulière non représentée, la buse qui fait partie intégrante du four, peut également être chauffée rapidement de l'extérieur. Cette mesure peut contribuer à une amélioration du processus de décomposition de l'hydrogène en ions H⁺, très actifs.

Des cales 118 d'épaisseur calibrée disposées entre la paroi 104 de la buse 100 et la sole 108 permettent de définir un espacement 119 constituant un échappement du gaz réducteur. Comme l'indiquent les flèches sur la figure, le gaz réducteur provenant de l'arrivée de gaz 112 traverse le diffuseur 110, vient lécher les composants 120 disposés dans l'espace intérieur 106 et s'échappe par l'espacement 119.

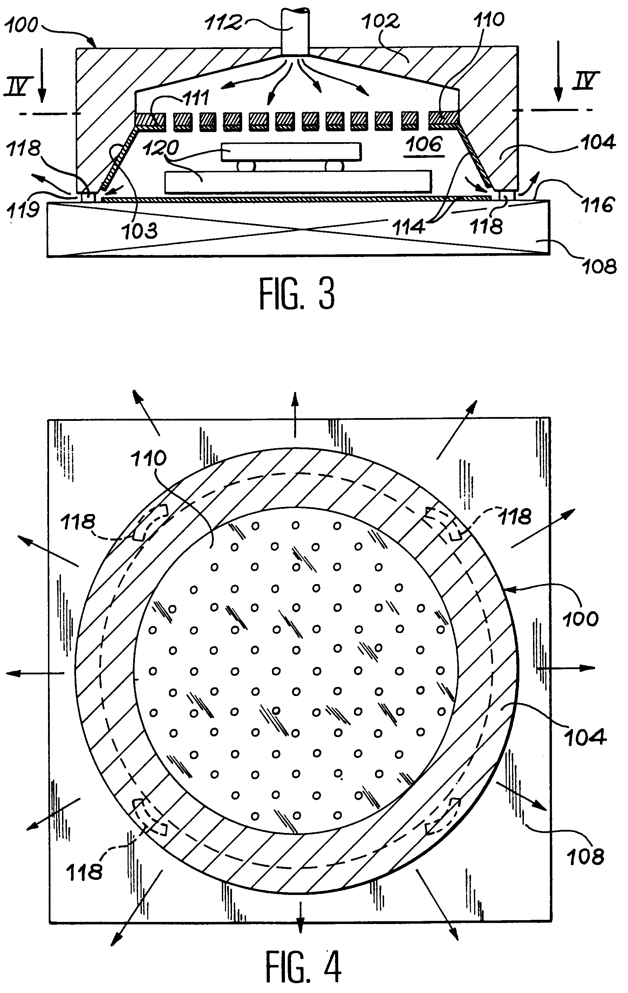

La figure 4 permet de mieux voir la répartition des cales 118 entre la paroi 104 de la buse 100 et la sole 108. Le diffuseur 110 est également représenté sur cette figure.

Des flèches indiquent l'échappement du gaz réducteur. La forme et le dimensionnement de l'échappement d'une part, le débit de gaz et le volume intérieur d'autre part sont ajustés pour obtenir une accélération du gaz à sa sortie du four sans créer de turbulence dans l'écoulement du gaz sur les composants à hybrider. Une bonne accélération des gaz permet également d'éviter une rétrodiffusion d'oxygène ou de vapeur d'eau dans le four.

A titre d'exemple, pour un volume utile de l'espace intérieur 106 de 1 litre, les cales présentent une épaisseur calibrée de 3 dixièmes de millimètre et le débit de gaz à l'entrée du four est ajusté à 2 litres par minute. Ainsi, il est possible de réduire la proportion d'oxygène dans le four à moins de 50 ppm (parties pour million). Le gaz réducteur choisi est par exemple un mélange N₂H₂ ou ArH₂ avec de 5 à 10% de gaz hydrogène (H₂).

Finalement, grâce à l'invention, il est possible d'augmenter de façon importante le rendement des interconnexions.

A titre d'exemple, dans un four non équipé d'une couche de palladium, recouvrant les parois intérieures, et dans une atmosphère de N₂H₂, le rendement est inférieur à 70%.

Ce rendement est par ailleurs voisin de celui obtenu dans une atmosphère d'azote pure, ce qui montre que dans le four non équipé, le caractère réducteur de l'hydrogène n'est quasiment pas mis à profit.

Dans un four conforme à l'invention, par contre, en utilisant comme gaz réducteur un mélange d'azote et d'hydrogène (N₂H₂) le rendement de l'hybridation est supérieur à 90%.

De plus, un four conforme aux caractéristiques de l'invention peut être réalisé avec une faible masse thermique et donc une faible inertie thermique. Les temps des cycles thermiques de l'hybridation peuvent ainsi être réduits.

## Revendications

1. Four à hybridation pour l'interconnexion de composants par un matériau fusible, avec des parois définissant une enceinte apte à recevoir les composants (120) à interconnecter, des moyens de chauffage (108) de l'enceinte et des moyens (100, 110, 112, 119) pour faire circuler un flux de gaz réducteur contenant de l'hydrogène à travers l'enceinte, caractérisé en ce que les parois de l'enceinte présentent une surface intérieure (103, 111, 116) au moins en partie recouverte d'un matériau comportant au moins un élément choisi dans le groupe VIIIB du tableau de la classification périodique des éléments, et en ce que l'enceinte (106) présente un volume intérieur ajusté par rapport aux composants à hybrider.

2. Four à hybridation selon la revendication 1, caractérisé en ce que l'élément choisi dans le groupe VIIIB du tableau de la classification périodique des éléments est choisi parmi le platine et le palladium.

3. Four à hybridation selon la revendication 1, caractérisé en ce que les moyens (100, 110, 112, 119) pour faire circuler un flux de gaz comportent une buse (100) d'introduction de gaz et un échappement (119), la buse et l'échappement présentant respectivement un débit d'entrée et un débit de sortie de gaz choisis pour créer un flux laminaire de gaz.

4. Four à hybridation selon la revendication 3, caractérisé en ce que le débit d'entrée et le débit de sortie sont choisis pour que l'enceinte contienne moins de 50 ppm d'oxygène.

5. Four à hybridation selon la revendication 3, caractérisé en ce que les moyens de chauffage comportent une sole chauffante (108).

6. Four à hybridation selon la revendication 5, caractérisé en ce que la sole chauffante (108) présente une capacité de montée en température supérieure ou égale à 3°C/s.

7. Four à hybridation selon la revendication 5, caractérisé en ce que la buse (100) d'introduction de gaz réducteur présente des parois supérieure (102) et latérale (104) et est disposée au-dessus de la sole chauffante pour former avec la sole l'enceinte du four à hybridation.

8. Four à hybridation selon la revendication 7, caractérisé en ce qu'il présente au moins une cale (118) d'épaisseur calibrée disposée entre la paroi latérale (104) de la buse (100) et la sole (108) pour définir un espacement constituant l'échappement.

9. Four à hybridation selon la revendication 3, caractérisé en ce que la buse (100) comporte un diffuseur (110) du gaz réducteur.

10. Procédé d'utilisation d'un four conforme à l'une quelconque des revendications précédentes, caractérisé en ce qu'on fait circuler dans le four un gaz réducteur choisi parmi le N₂H₂ et le ArH₂.

## Claims

1. Hybridization oven for the interconnection of components using a fusible material, with walls defining a chamber capable of accommodating the components (120) to be interconnected, means (108) for heating the chamber and means (100, 110, 112, 119) for creating a flow of reducing gas containing hydrogen through the chamber, characterized in that the walls of the chamber have an internal surface (103, 111, 116) at least partly covered with a material comprising at least one element chosen from Group VIIIB of the Periodic Table of Elements and in that the chamber (106) has an internal volume which is adjusted with respect to the components to be hybridized.

2. Hybridization oven according to Claim 1, characterized in that the element chosen from Group VIIIB of the Periodic Table of Elements is chosen from platinum and palladium.

3. Hybridization oven according to Claim 1, characterized in that the means (100, 110, 112, 119) for creating a gas flow comprise a gas injection nozzle (100) and an exhaust (119), the nozzle and the exhaust having, respectively, a gas inlet flow rate and a gas outlet flow rate which are chosen in order to create a laminar gas flow.

4. Hybridization oven according to Claim 3, characterized in that the inlet flow rate and the outlet flow rate are chosen so that the chamber contains less than 50 ppm of oxygen.

5. Hybridization oven according to Claim 3, characterized in that the heating means comprise a heating sole (108).

6. Hybridization oven according to Claim 5, characterized in that the heating sole (108) has a capability of raising the temperature at a rate of greater than or equal to 3°C/s.

7. Hybridization oven according to Claim 5, characterized in that the reducing-gas injection nozzle (100) has an upper wall (102) and a side wall (104) and is placed over the heating sole in order to form, together with the sole, the chamber of the hybridization oven.

8. Hybridization oven according to Claim 7, characterized in that it has at least one calibrated shim (118) placed between the side wall (104) of the nozzle (100) and the sole (108) in order to define a space constituting the exhaust.

9. Hybridization oven according to Claim 3, characterized in that the nozzle (100) comprises a reducing-gas diffuser (110).

10. Method of using an oven according to any one of the preceding claims, characterized in that a reducing gas chosen from N₂H₂ and ArH₂ is made to flow in the oven.

## Patentansprüche

1. Hybridisierungsofen für die Verbindung von Bauelementen mittels eines schmelzbaren Materials mit Wänden, die eine Kammer zur Aufnahme der zu verbindenden Bauelemente (120) bilden, Heizeinrichtungen (108) der Kammer und Einrichtungen (100, 110, 112, 119), um einen Strom eines reduzierenden, Wasserstoff enthaltenden Gases durch die Kammer strömen zu lassen,
**dadurch gekennzeichnet**,
daß die Wände der Kammer eine Innenoberfläche (103, 111, 116) aufweisen, die wenigstens teilweise mit einem Material beschichtet ist, das wenigstens ein aus der Gruppe VIIIB des periodischen Systems der Elemente ausgewähltes Element enthält, und dadurch, daß die Kammer (106) ein in bezug auf die zu hybridisierenden Bauelemente angepaßtes Innenvolumen aufweist.

2. Hybridisierungsofen nach Anspruch 1, dadurch gekennzeichnet, daß das aus der Gruppe VIIIB des periodischen Systems der Elemente ausgewählte Element entweder Platin oder Palladium ist.

3. Hybridisierungsofen nach Anspruch 1, dadurch gekennzeichnet, daß die Einrichtungen (100, 110, 112, 119), um einen Gasstrom fließen zu lassen, eine Eintrittsdüse (100) und einen Auslaß (119) umfassen, wobei die Düse und der Auslaß jeweils eine solche Gas-Eintrittsmenge beziehungsweise -Austrittsmenge aufweisen, daß eine laminare Gasströmung entsteht.

4. Hybridisierungsofen nach Anspruch 3, dadurch gekennzeichnet, daß die Eintrittsmenge und die Austrittsmenge so gewählt werden, daß die Kammer weniger als 50ppm Sauerstoff enthält.

5. Hybridisierungsofen nach Anspruch 3, dadurch gekennzeichnet, daß die Heizeinrichtungen eine Ofensohle (108) umfassen.

6. Hybridisierungsofen nach Anspruch 5, dadurch gekennzeichnet, daß die Ofensohle (108) eine Temperaturanstiegskapazität höher oder gleich 3°C/s aufweist.

7. Hybridisierungsofen nach Anspruch 5, dadurch gekennzeichnet, das die Einlaßdüse (100) des reduzierenden Gases obere (102) und seitliche (104) Wände aufweist und über der Ofensohle angeordnet ist, um mit der Sohle die Kammer des Hybridisierungsofens zu bilden.

8. Hybridisierungsofen nach Anspruch 7, dadurch gekennzeichnet, daß er wenigstens ein Abstandsstück (118) von kalibrierter Dicke umfaßt, angeordnet zwischen der Seitenwand (104) der Düse (100) und der Sohle (108), um einen den Auslaß bildenden Zwischenraum zu definieren.

9. Hybridisierungsofen nach Anspruch 3, dadurch gekennzeichnet, daß die Düse (100) einen Diffusor (110) des reduzierenden Gases umfaßt.

10. Verfahren zur Benutzung eines Ofen nach einem der vorangehenden Ansprüche, dadurch gekennzeichnet, daß man in dem Ofen ein zwischen N₂H₂ und ArH₂ ausgewähltes reduzierendes Gas strömen läßt.
